# DEMANDE DE BREVET EUROPEEN

(11) **EP 4 411 828 A1**
(43) Date de publication de la demande: **07.08.2024**
(21) Numéro de dépôt: 24155549.9
(22) Date de dépôt: 02.02.2024
(51) Int. Cl.: H01L 29/778, H01L 21/337, H01L 29/10, H01L 29/40, H01L 21/223, H01L 29/20

(54) **TRANSISTOR HEMT**

(30) Priorité: 06.02.2023 FR 2301105
(71) Demandeur: STMicroelectronics International N.V., 1228 Plan-les-Ouates, Geneva (CH)
(72) Inventeur: CONSTANT, Aurore, 37100 TOURS (FR); IUCOLANO, Ferdinando, 95030 GRAVINA DI CATANIA (IT); TRINGALI, Cristina, 96011 AUGUSTA (IT); CASTAGNA, Maria Eloisa, 95123 CATANIA (IT)
(74) Mandataire: Cabinet Beaumont

(57) **Abrégé**

La présente description concerne un procédé de formation d'un transistor HEMT (41) comportant les étapes successives suivantes :
a) prévoir un empilement comportant une couche semiconductrice de canal (23), une couche semiconductrice barrière (13) sur et en contact avec la couche semiconductrice de canal (23) et une couche semiconductrice de grille (15) disposée sur et en contact avec la couche semiconductrice barrière (13), la couche semiconductrice de grille (15) comportant des éléments dopants de type P ; et
b) compenser le dopage de type P par des atomes d'oxygène, dans une partie supérieure (151) de la couche semiconductrice de grille (15), par un recuit sous oxygène, de manière à définir une jonction PN à l'interface entre la partie supérieure (151) et une partie centrale (153) de la couche semiconductrice de grille (15).

## Description

### Domaine technique

La présente description concerne de façon générale le domaine des transistors et plus particulièrement le domaine des transistors à haute mobilité électronique aussi appelés HEMT (de l'anglais "High Electron Mobility Transistor").

### Technique antérieure

Les transistors HEMT reposent sur une hétérojonction en surface de laquelle se forme un gaz bidimensionnel d'électrons appelé 2DEG.

Il existe un besoin d'amélioration des transistors HEMT et de leurs procédés de fabrication.

### Résumé de l'invention

Pour cela, un mode de réalisation prévoit un procédé de formation d'un transistor HEMT comportant les étapes successives suivantes :
a) prévoir un empilement comportant une couche semiconductrice de canal, une couche semiconductrice barrière sur et en contact avec la couche semiconductrice de canal et une couche semiconductrice de grille disposée sur et en contact avec la couche semiconductrice barrière, la couche semiconductrice de grille comportant des éléments dopants de type P ; et
b) compenser le dopage de type P par des atomes d'oxygène, dans une partie supérieure de la couche semiconductrice de grille, par un recuit sous oxygène, de manière à définir une jonction PN à l'interface entre la partie supérieure et une partie centrale de la couche semiconductrice de grille.

Selon un mode de réalisation, le procédé comporte une étape c) de gravure de la couche semiconductrice de grille.

Selon un mode de réalisation, la gravure de l'étape c) est réalisée après l'étape b).

Selon un mode de réalisation :
- la gravure de l'étape c) est partielle, une partie de l'épaisseur de la couche semiconductrice de grille subsistant à l'issue de l'étape de gravure ; et
- la gravure de l'étape c) est suivie d'une autre étape de compensation du dopage de type P par des atomes d'oxygène dans une partie périphérique de la couche semiconductrice gravée et d'une autre étape de gravure permettant de retirer ce qui subsiste de la couche semiconductrice de grille à l'issue de l'étape de gravure de l'étape c).

Un autre mode de réalisation prévoit un transistor HEMT comportant :
- une couche semiconductrice de canal ;
- une couche semiconductrice barrière sur et en contact avec la couche semiconductrice de canal ; et
- une grille semiconductrice disposée sur et en contact avec une première face de la couche semiconductrice barrière, opposée à la couche semiconductrice de canal, dans lequel la grille comprend une partie supérieure et une partie centrale, la partie supérieure et la partie centrale comportant des éléments dopants de type P, et la partie supérieure comportant des atomes d'oxygène compensant le dopage de type P de manière à définir une jonction PN à l'interface entre la partie centrale et la partie supérieure.

Selon un mode de réalisation, la grille comprend une partie périphérique comportant des éléments dopants de type P et comportant des atomes d'oxygène compensant le dopage de type P.

Selon un mode de réalisation, le transistor comporte une couche de passivation s'étendant sur la première face de la première couche semiconductrice et les flancs de la grille et une partie périphérique d'une face de la grille opposée à la première couche semiconductrice.

Selon un mode de réalisation, la première couche de passivation est en alumine.

Selon un mode de réalisation, la première couche semiconductrice est à base de nitrure de gallium.

Selon un mode de réalisation, la première couche semiconductrice est en nitrure d'aluminium-gallium.

Selon un mode de réalisation, la première couche semiconductrice comprend un pourcentage en aluminium décroissant à partir de sa première face.

Selon un mode de réalisation, le transistor comporte une deuxième couche semiconductrice en contact avec une deuxième face de la première couche semiconductrice, opposée à la première face.

Selon un mode de réalisation, la deuxième couche semiconductrice est en nitrure de gallium.

Selon un mode de réalisation, la grille semiconductrice est en nitrure de gallium.

Un autre mode de réalisation prévoit un circuit de conversion ou d'adaptation de puissance comportant au moins un transistor tel que décrit.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 est une vue en coupe, partielle et schématique, d'un exemple d'un transistor HEMT ;
la figure 2 est une vue en coupe, partielle et schématique, d'un transistor HEMT selon un premier mode de réalisation ;
la figure 3A, la figure 3B, la figure 3C, la figure 3D, la figure 3E et la figure 3F sont des vues en coupe illustrant des étapes d'un exemple d'un procédé de fabrication du transistor HEMT illustré en figure 2 ;
la figure 4 est une vue en coupe, partielle et schématique, d'un transistor HEMT selon un deuxième mode de réalisation ; et
la figure 5 est une vue en coupe, partielle et schématique, d'un transistor HEMT selon un troisième mode de réalisation.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés. En particulier, les applications que peuvent avoir les transistors HEMT décrits, ne sont pas détaillées, les modes de réalisation étant compatibles avec les applications usuelles des transistors HEMT. On s'intéresse ici tout particulièrement au domaine des transistors HEMT dits de puissance, capables de tenir des tensions relativement élevées à l'état bloqué, par exemple des tensions de l'ordre de 100 à 650 volts. Les transistors décrits peuvent, par exemple, être utilisés dans divers circuits de conversion ou d'adaptation de puissance, par exemple dans des équipements industriels, des dispositifs d'affichage ou d'éclairage, des équipements de télécommunications, des dispositifs automobiles, etc.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % près, de préférence à 5 % près.

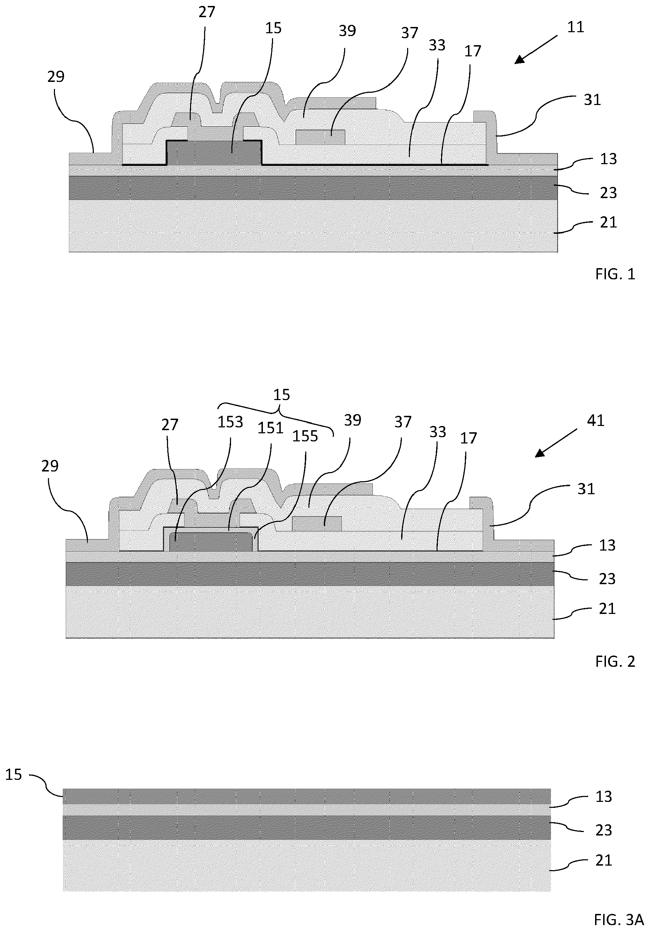

La figure 1 est une vue en coupe, partielle et schématique, d'un exemple d'un transistor HEMT 11.

Le transistor HEMT 11 comporte une première couche semiconductrice 13 appelée couche barrière, disposée sur une deuxième couche conductrice 23 appelée couche de canal. La couche semiconductrice 23 est par exemple en contact, par sa face inférieure, avec la face supérieure de la couche conductrice 23. A titre d'exemple, l'empilement comprenant la couche semiconductrice 13 et la couche semiconductrice 23 repose sur un substrat 21. La couche semiconductrice 23 est par exemple en contact, par sa face inférieure, avec la face supérieure du substrat 21. L'interface entre la couche semiconductrice 13 et la couche semiconductrice 23 définit une hétérojonction à la surface de laquelle un gaz bidimensionnel d'électrons 2DEG aussi appelé canal d'électrons est formé.

Les couches semiconductrices 13 et 23 sont par exemple en des matériaux semiconducteurs de type III-V, par exemple à base de nitrure de gallium (GaN). La couche semiconductrice 13 est par exemple en nitrure d'aluminium-gallium (AlGaN). La couche semiconductrice 13 est par exemple en nitrure de gallium (GaN).

A titre d'exemple, le substrat 21 est en un matériau semiconducteur. Le substrat 21 est par exemple en silicium, ou en carbure de silicium. En variante, le substrat 21 est en nitrure d'aluminium. Le substrat 21 comprend par exemple, du côté de sa face supérieure, une couche tampon ("buffer layer" en anglais), non détaillée sur les figures, par exemple en nitrure de gallium. La couche tampon est par exemple en contact, par sa face supérieure, avec la face inférieure de la couche semiconductrice 23.

Le transistor HEMT 11 comporte une grille 15 sur la face supérieure de la couche semiconductrice 13. La grille 15 est par exemple en contact, par sa face inférieure, avec la face supérieure de la couche semiconductrice 13.

La grille 15 est par exemple en un matériau semiconducteur, par exemple en un matériau semiconducteur de type III-V, par exemple en nitrure de gallium. La grille 15 comprend des éléments dopants de type P, par exemple des atomes de magnésium. A titre d'exemple, la grille 15 a une épaisseur comprise entre 20 nm et 200 nm, par exemple comprise entre 80 nm et 120 nm, par exemple de l'ordre de 100 nm.

A titre d'exemple, le transistor HEMT 11 comprend, en outre, une métallisation de contact de source 29 et une métallisation de contact de drain 31. A titre d'exemple, les métallisations de contact 29 et 31 sont à base de titane, de nitrure de titane et/ou d'un alliage d'aluminium et de cuivre. Les métallisations de contact de source 29 et de drain 31 définissent par exemple chacune un contact ohmique avec la couche semiconductrice 13. Les métallisations de contact 29 et 31 sont par exemple situées sur et en contact avec la couche semiconductrice 13, de part et d'autre de la grille 15.

Le transistor HEMT 11 comporte, en outre, une couche de passivation 17 recouvrant les flancs de la grille, une partie de la face supérieure de la grille 15 et se prolongeant sur une partie de la face supérieure de la couche semiconductrice 13 non recouverte par la grille 15. A titre d'exemple, la couche de passivation 17 est en contact, par sa face inférieure, avec la face supérieure de la couche semiconductrice 13. La couche de passivation 17 est par exemple en outre en contact avec les flancs de la grille 15. Dans le mode de réalisation de la figure 1, la couche de passivation 17 s'étend latéralement entre les métallisations de contact de source 29 et de drain 31.

La couche de passivation 17 a par exemple une épaisseur comprise entre 2 nm et 20 nm, par exemple comprise entre 2 nm et 10 nm, par exemple de l'ordre de 5 nm. La couche de passivation 17 est par exemple en un matériau diélectrique, par exemple en alumine (Al₂O₃), en dioxyde de silicium (SiO₂), en nitrure de silicium (Si₃N₄) en nitrure d'aluminium (AlN) ou en oxyde d'hafnium (HfO₂).

La grille 15 est par exemple surmontée par une métallisation de contact de grille 27.

A titre d'exemple, la métallisation de contact de grille 27 est en contact, par sa face inférieure, avec la face supérieure de la grille 15. La métallisation de contact de grille 27 s'étend alors à travers la couche 17 qui ne recouvre la face supérieure de la grille 15 que sur sa périphérie.

A titre d'exemple, la métallisation de contact de grille 27 est à base de nitrure de titane et/ou de titane, et/ou de tantale, et/ou un alliage de tungstène et de tantale et/ou un alliage de tungstène et de titane et/ou d'un alliage d'aluminium et de cuivre.

Dans cet exemple, la métallisation 27 définit un contact Schottky avec la grille semiconductrice 15. La grille semiconductrice 15 et la métallisation 27 définissent une diode Schottky dont l'anode correspond à la grille semiconductrice 15 et dont la cathode correspond à la métallisation 27.

Le transistor HEMT 11 comprend par exemple plusieurs niveaux de couches isolantes dans, et par exemple sur, lesquelles sont formés des métallisations.

A titre d'exemple, le transistor HEMT 11 comprend une couche isolante 33 sur et en contact avec la face supérieure de la couche de passivation 17. A titre d'exemple, la couche isolante 33 recouvre l'ensemble de la surface de la couche de passivation 17. La couche isolante 33 est par exemple ouverte en vis-à-vis d'une partie centrale de la face supérieure de la grille 15 de façon à être traversée par la métallisation de contact de grille 27. La couche isolante 33 est par exemple en un matériau diélectrique, par exemple en un oxyde, par exemple en dioxyde de silicium (SiO₂) ou en nitrure de silicium (Si₃N₄).

A titre d'exemple, le transistor HEMT 11 comprend une région métallique 37 s'étendant sur une partie de la surface de la couche isolante 33. A titre d'exemple, la région métallique 37 est à base de nitrure de titane et/ou de titane, et/ou de tantale, et/ou un alliage de tungstène et de tantale et/ou un alliage de tungstène et de titane et/ou d'un alliage d'aluminium et de cuivre. La région métallique 37 est par exemple en le même matériau que la métallisation de contact de grille 27.

Le transistor HEMT 11 peut comprendre une deuxième couche isolante 39 recouvrant l'ensemble de la structure à l'exception des métallisations de contact de source 29 et de drain 31. La deuxième couche isolante 39 est, par exemple en le même matériau que la couche isolante 33.

Les régions métalliques 37 et 41 ont par exemple pour fonction de modifier le profil de la distribution du champ électrique du bord de la grille, situé du côté du drain (le bord droit de la grille en figure 1), et de réduire le pic du champ électrique critique, augmentant ainsi la tension d'avalanche. Les régions métalliques 37 et 41 sont par exemple appelées "field plates" ou plaques de champ.

A titre d'exemple, la métallisation de contact de source 29 se prolonge sur la face supérieure de la couche isolante 39 en direction de la métallisation de contact de drain 31, sans atteindre la métallisation de contact de drain 31.

Dans le transistor de la figure 1, le canal 2DEG est par exemple normalement fermé ("normally-off" en anglais), c'est-à-dire qu'il est interrompu sous la grille 15 ce qui empêche la circulation d'un courant entre la source et le drain du transistor. On dit que le transistor est à l'état bloqué. Le canal peut être rétabli (c'est à dire rendu passant) par la polarisation de la grille 15. Dans ce cas, un courant peut s'établir entre la source et le drain du transistor. Les modes de réalisation décrits peuvent également s'appliquer à des transistors normalement ouvert ("normally-on" en anglais).

La présence de la couche de passivation 17 permet la protection de la face supérieure de la couche semiconductrice 13 sur laquelle des liaisons pendantes peuvent être présentes et susceptibles de générer des courants de fuite et/ou une diminution de la tenue en tension du transistor. La couche de passivation 17 comble ces liaisons afin de rendre la surface de la couche semiconductrice 13 électriquement inactive.

La couche de passivation 17 permet également de protéger la couche semiconductrice 13 contre l'oxydation et d'améliorer son état de surface auquel le canal 2DEG est sensible.

Alors que la couche de passivation 17 joue un rôle important dans la qualité et la durée de vie du transistor, sa présence peut entraîner l'accumulation d'électrons le long des flancs de la grille 15, sous la couche de passivation 17. Ce phénomène est par exemple accentué par l'endommagement des flancs de la grille causé par la gravure de la grille 15. Il en résulte l'apparition de courants de fuite entre la métallisation de contact de grille 27 et les métallisations de source 29 et/ou de drain 31, passant par les flancs de la grille.

Afin de réduire ce phénomène, on propose de modifier le dopage d'une partie supérieure de la grille semiconductrice 15, de façon à obtenir un dopage de type N dans cette partie supérieure, et ainsi définir une jonction PN entre cette partie supérieure et une partie inférieure de la grille. La métallisation de contact 27 forme alors un contact ohmique avec la partie supérieure de type N de la grille semiconductrice 15. Ainsi, la diode Schottky formée, dans l'exemple de la figure 1, entre la grille semiconductrice 15 et la métallisation 27, est remplacée par une diode PN formée entre la partie inférieure et la partie supérieure de la grille semiconductrice 15.

La figure 2 est une vue en coupe, partielle et schématique, d'un transistor HEMT 41 selon un premier mode de réalisation.

Plus particulièrement, la figure 2 illustre un transistor HEMT 41 similaire au transistor 11 illustré en figure 1 à la différence près que la grille 15 du transistor 41 comprend, dans une partie supérieure 151 et dans une partie périphérique 155 de la grille des atomes d'oxygène compensant le dopage de type P de manière à obtenir un dopage de type N et ainsi définir une jonction PN à l'interface entre une partie centrale 153 et les parties supérieure 151 et périphérique 155 de la grille.

A titre d'exemple, la partie supérieure de type N 151 a une épaisseur comprise entre 10 nm et 100 nm, par exemple comprise entre 30 nm et 70 nm, par exemple de l'ordre de 50 nm. A titre d'exemple, la partie périphérique de type N 155 a une épaisseur comprise entre 10 nm et 100 nm, par exemple comprise entre 30 nm et 70 nm, par exemple de l'ordre de 50 nm.

A titre d'exemple, la grille 15 est en nitrure d'aluminium-gallium. A titre d'exemple, la grille 15 est en un nitrure d'aluminium-gallium dont la formule chimique correspond à AlₓGaₓ₋₁N, dans lequel x est un entier positif. La grille 15 comprend des éléments dopants de type P, par exemple des atomes de magnésium.

A titre d'exemple, la couche semiconductrice 13 comprend un pourcentage en aluminium non homogène dans l'ensemble de son épaisseur. La couche 13 a, par exemple, un pourcentage d'aluminium croissant à partir de sa face inférieure, c'est à dire qu'elle a un pourcentage en aluminium au voisinage de la grille 15 supérieur à celui au voisinage de la couche semiconductrice 23.

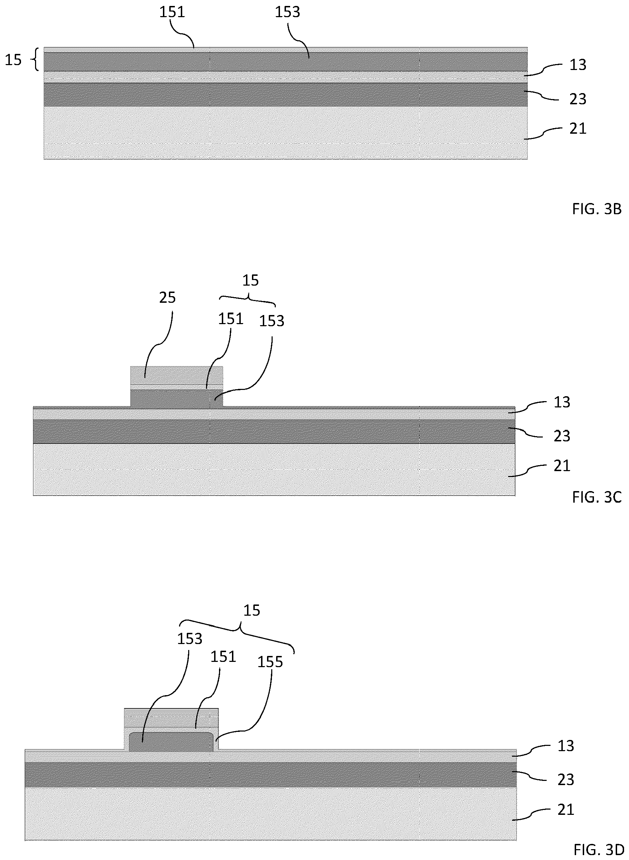

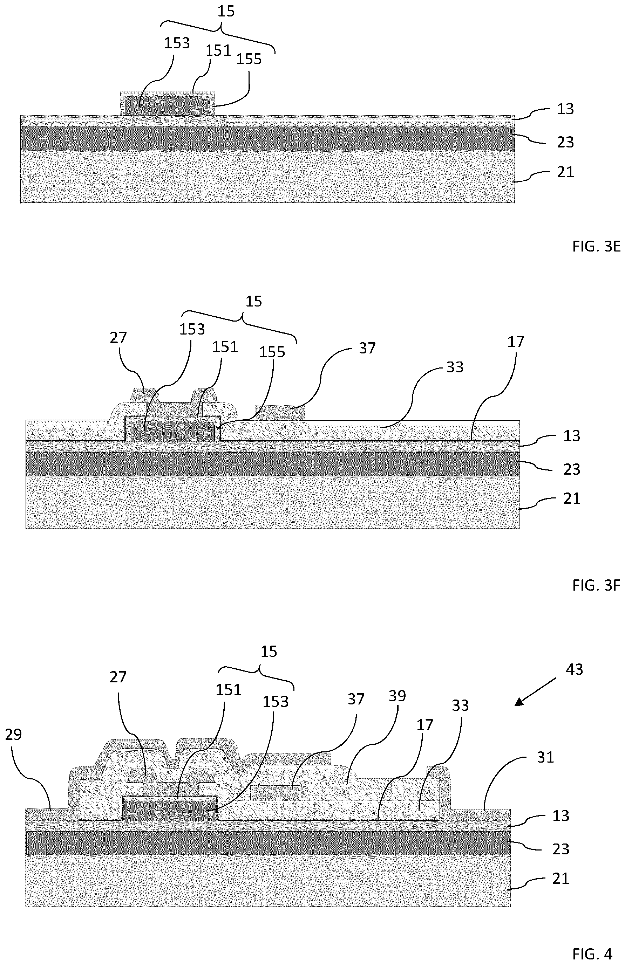

La figure 3A, la figure 3B, la figure 3C, la figure 3D, la figure 3E et la figure 3F sont des vues en coupe illustrant des étapes d'un exemple d'un procédé de fabrication du transistor HEMT 41 illustré en figure 2.

La figure 3A illustre une structure de départ comprenant, dans l'ordre, à partir de la face inférieure de la structure, le substrat 21, la deuxième couche semiconductrice 23 et la première couche semiconductrice 13. La structure de départ comprend, en outre, une couche de grille 15 dans laquelle la grille 15 du transistor 41 sera formée. Dans la structure de départ illustrée en figure 3A, les couches 23, 13 et 15 s'étendent chacune de façon continue et avec une épaisseur sensiblement uniforme sur toute la surface supérieure du substrat 21.

A titre d'exemple, la couche de grille 15 est formée sur la face supérieure de la couche 13, par un procédé de dépôt en phase vapeur, par exemple un procédé d'épitaxie en phase vapeur organométallique aussi appelé procédé de dépôt chimique en phase vapeur organométallique ou MOCVD (de l'anglais "Metalorganic chemical vapor déposition"). A titre d'exemple, le dépôt de la couche de grille 15 est réalisé sous un vide au moins partiel. La couche de grille 15 est, par exemple, dopée lors de son dépôt. En variante, la couche de grille 15 est dopée après son dépôt par une étape d'implantation de dopants. Dans cet exemple, la couche de grille 15 est dopée de type P, par exemple par des atomes de magnésium.

La figure 3B illustre une structure obtenue à l'issue d'une première étape de compensation du dopage de la couche de grille 15 par des atomes d'oxygène, dans une partie supérieure de la couche de grille (15).

Plus particulièrement, lors de cette étape, on vient effectuer un recuit sous oxygène, et par exemple sous diazote, de la structure illustrée en figure 3A de sorte que le dopage de type P d'une partie supérieure de la couche de grille 15 soit compensé par des atomes d'oxygène. La partie supérieure de la couche de grille 15 change alors de type de dopage, on parle alors de compensation de dopage. Ici, une partie supérieure de la couche de grille 15 passe d'un dopage de type P à un dopage de type N.

En pratique, le recuit sous oxygène, par exemple sous diazote, permet, dans un premier temps, de délier des atomes d'hydrogène liés aux éléments dopants présents dans la couche de grille, par exemple des atomes de magnésium. Dans un second temps, le recuit sous oxygène, et par exemple sous diazote, permet l'implantation d'atomes d'oxygène, qui sont des éléments dopants de type N, dans la structure et plus particulièrement dans la partie supérieure de la couche de grille 15.

A titre d'exemple, le recuit sous oxygène comprend un pourcentage d'oxygène compris entre 1 % et 20 %, par exemple compris entre 2 % et 10 %, par exemple de l'ordre de 5 %. Le recuit sous oxygène est par exemple réalisé à une température comprise entre 600 °C et 1000 °C, par exemple comprise entre 750 °C et 900 °C, par exemple de l'ordre de 820 °C.

A l'issue de cette étape, la couche de grille 15 comprend une partie supérieure 151 et une partie centrale 153 dont l'interface définit une jonction PN.

La figure 3C illustre une structure obtenue à l'issue d'une première étape de gravure de la couche de grille 15.

Plus particulièrement, lors de cette étape, on vient dans un premier temps par exemple former une couche de masquage 25 sur et, par exemple en contact avec, la structure illustrée en figure 3B. La couche de masquage 25 est par exemple en un matériau résistant à la gravure décrite ci-après, par exemple en un oxyde, par exemple en orthosilicate de tétraéthyle ou TEOS (de l'anglais "Tetraethyl orthosilicate"). A titre d'exemple, la couche de masquage 25 n'est pas en une résine. La couche de masquage 25 a par exemple une épaisseur comprise entre 50 nm et 200 nm, par exemple de l'ordre de 100 nm. A titre d'exemple, la couche de masquage 25 est formée de sorte qu'elle recouvre la structure illustrée en figure 3B à l'emplacement de la future grille 15.

Lors de cette étape, on vient dans un second temps graver la couche de grille 15 à travers la couche de masquage 25 par exemple par un procédé de gravure plasma, par exemple par un procédé de gravure plasma à base de chlore, par exemple par une gravure plasma en trichlorure de bore (BCl₃) et dichlore (Cl₂).

La couche de grille 15 et plus précisément la partie de la couche de grille 15 située hors du vis-à-vis de la couche de masquage 25 est, lors de cette étape, gravée partiellement, c'est-à-dire qu'elle est gravée sur une partie seulement de son épaisseur. A titre d'exemple, lors de cette étape, la couche de grille 15 est gravée sur 50 % à 90 % de son épaisseur, par exemple sur 80 % de son épaisseur.

A l'issue de cette étape, la couche de grille 15 subsiste en vis-à-vis de la couche de masquage 25 et hors du vis-à-vis de la couche de masquage 25 uniquement sur une partie de son épaisseur.

La figure 3D illustre une structure obtenue à l'issue d'une deuxième étape de compensation du dopage de la couche de grille 15 par des atomes d'oxygène.

Plus particulièrement, lors de cette étape, on vient effectuer un recuit sous oxygène de la structure illustrée en figure 3C similairement à ce qui a été décrit en relation avec la figure 3B. Cette étape est par exemple réalisée alors que la couche de masquage 25 est encore présente à la surface de la structure. Les flancs de la partie de la couche de grille 15 située sous la couche de masquage 25 et une partie supérieure de ce qui subsiste de la couche de grille 15 hors du vis-à-vis de la couche de masquage 25 sont alors compensés par des atomes d'oxygène.

A l'issue de cette étape, la couche de grille 15 comprend la partie supérieure 151 et une partie périphérique 155 dopées du type N et la partie centrale 153 dopée de type P. A titre d'exemple, la partie périphérique 155 de la couche de grille 15 a une épaisseur comprise entre 10 nm et 100 nm, par exemple comprise entre 30 nm et 70 nm, par exemple de l'ordre de 50 nm.

Laisser subsister une partie de la couche de grille 15 hors du vis-à-vis de la couche de masquage 25 permet, lors de cette étape, de protéger la couche semiconductrice 13 et de compenser le dopage de la couche de grille 15 sans modifier le dopage de la couche semiconductrice 13.

La figure 3E illustre une structure obtenue à l'issue d'une deuxième étape de gravure de la couche de grille 15 à travers la couche de masquage 25 de façon à former la grille 15.

Lors de cette étape, on vient par exemple graver ce qui subsiste de la couche de grille 15 hors du vis-à-vis de la couche de masquage 25 par exemple par un procédé de gravure plasma, par exemple par un procédé de gravure plasma à base de chlore, par exemple par une gravure plasma à base de dichlore (Cl₂) et dioxygène (O₂) ou par une gravure plasma à base de trichlorure de bore (BCl₃) et d'hexafluorure de soufre (SF₆).

A titre d'exemple, l'étape de gravure est poursuivie jusqu'à ce que la face supérieure de la couche semiconductrice 13 soit dévoilée et que la couche de grille 15 ne subsiste qu'en vis-à-vis de la couche de masquage 25 de façon à former la grille 15 du transistor.

Cette étape de gravure est, par exemple suivie d'une étape de retrait de la couche de masquage 25. A titre d'exemple, le retrait du masque de gravure est réalisé à l'aide de fluorure d'hydrogène (HF).

La figure 3F illustre une structure obtenue à l'issue d'une étape de formation de la couche de passivation 17, de la couche isolante 33, de la métallisation 27 et de la région 37 sur la face supérieure de la structure illustrée en figure 3E.

Lors de cette étape, on vient dans un premier temps former la couche de passivation 17 pleine plaque, de sorte qu'elle recouvre l'ensemble de la face supérieure de la structure illustrée en figure 3E.

La couche de passivation 17 est, par exemple, formée en contact avec la face supérieure de la couche semiconductrice 13 et les flancs et la face supérieure de la grille 15. La couche de passivation 17 est par exemple formée par un procédé de dépôt de couche mince, par exemple par ALD. A titre d'exemple, le procédé de dépôt de la couche de passivation 17 est assisté par plasma ou thermique. A titre d'exemple, la couche de passivation 17 a une épaisseur comprise entre 1 nm et 10 nm, par exemple comprise entre 3 nm et 7 nm, par exemple de l'ordre de 5nm.

Dans un second temps, on vient, lors de cette étape, former la couche isolante 33 pleine plaque, de sorte qu'elle recouvre l'ensemble de la face supérieure de la couche de passivation 17. La couche isolante 33 est par exemple formée en contact avec la couche de passivation 17. La couche isolante 33 est par exemple formée par un procédé de dépôt chimique en phase vapeur assisté par plasma ou PECVD (de l'anglais "Plasma-Enhanced Chemical Vapor Déposition"). A l'issue de cette étape, la couche isolante 33 a une épaisseur par exemple comprise entre 150 nm et 400 nm, par exemple comprise entre 200 nm et 350 nm, par exemple de l'ordre de 300 nm.

A titre d'exemple, les étapes de dépôt de la couche de passivation 17 et de la couche isolante 33 sont précédées d'une ou plusieurs étapes de préparation de la surface de la structure illustrée en figure 3E. La préparation de la surface de la structure illustrée en figure 3E peut comprendre un nettoyage consistant par exemple en un nettoyage chimique à l'aide d'acide, par exemple de chlorure d'hydrogène (HCl) et de fluorure d'hydrogène (HF). La préparation de la surface de la structure illustrée en figure 3E peut, en outre, comprendre un nettoyage consistant par exemple en une oxydation de surface. La couche de passivation 17 sera ainsi formée au contact d'un film d'oxyde, lui-même formé au contact de la face supérieure de la couche 13.

Lors de cette étape, dans un troisième temps, on vient retirer la couche de passivation 17 et la couche isolante 33 en vis-à-vis d'une partie centrale de la face supérieure de la grille 15 et former la métallisation de contact de grille 27 dans l'ouverture formée. A titre d'exemple, cette étape comprend le retrait de la couche 33 puis le retrait de la couche 17. A titre d'exemple, le retrait de la couche 33 est réalisé par gravure plasma, par exemple à base de fluor, par exemple à base de tétrafluorure de carbone (CF₄). A titre d'exemple, le retrait de la couche 17 est réalisé par gravure plasma, par exemple à base de chlore, par exemple à base de trichlorure de bore (BCl₃). Dans cet exemple, la couche 17 est gravée de façon à dévoiler la face supérieure de la grille 15.

Les gravures susmentionnées sont par exemple suivies d'une étape de nettoyage de la face supérieure de la structure de façon à retirer par exemple les résidus issus de la couche de masquage 25 et les impuretés issues de la gravure de la couche de grille 15. Le nettoyage de la structure comporte par exemple une étape de décapage ("stripping" en anglais) par plasma de dioxygène et diazote (N₂). Le nettoyage de la structure peut en outre comporter une étape de retrait des résidus organiques à l'aide d'un solvant.

Lors de cette étape, on vient par exemple former la métallisation de contact de grille 27 dans l'ouverture formée dans les couches 17 et 33 en vis-à-vis de la partie centrale de la grille 15. A titre d'exemple, la métallisation de contact de grille 27 est formée sur et en contact avec la face supérieure de la grille 15 et plus précisément sur et en contact avec la partie supérieure 151 de la grille 15.

A titre d'exemple, lors de cette étape, on vient en outre former la région 37 sur une partie de la surface de la première couche isolante 33. La métallisation de contact de grille 27 et la région 37 sont, par exemple, formées par dépôt d'une ou plusieurs couches en un matériau métallique suivie d'une étape de gravure.

A titre d'exemple, l'étape de formation de la métallisation de contact de grille 27 et de la région 37 est précédée d'une étape de préparation de la surface de la structure, consistant par exemple en un nettoyage chimique à l'aide d'acide, par exemple de chlorure d'hydrogène (HCl).

A l'issue de cette étape, la couche isolante 39 est par exemple formée sur la face supérieure de la structure illustrée en figure 3F. Lors de cette étape, on vient par exemple former la couche isolante 39 pleine plaque, de sorte qu'elle recouvre l'ensemble de la face supérieure de la structure illustrée en figure 3F, c'est-à-dire la face supérieure et les flancs de la métallisation de contact de grille 27 et de la région 37 et une partie de la couche 33. La couche isolante 39 est par exemple formée par un procédé identique au procédé de formation de la couche 33 décrit en relation avec la figure 3F. A l'issue de cette étape, la couche isolante 39 a une épaisseur par exemple comprise entre 150 nm et 400 nm, par exemple comprise entre 200 nm et 350 nm, par exemple de l'ordre de 300 nm.

Pour finir, on vient, par exemple former les contacts ohmiques et plus particulièrement les métallisations de contact de source 29 et de drain 31 de façon à former la structure illustrée en figure 2.

Pour cela, des ouvertures destinées à recevoir les métallisations de contact de source 29 et de drain 31 sont, dans un premier temps, créées dans les couches 17, 33 et 39. Les ouvertures sont par exemple formées par un procédé de gravure plasma, par exemple à base de fluor, par exemple à base de tétrafluorure de carbone (CF₄). La gravure susmentionnée est par exemple sélective et ne grave pas la couche semiconductrice 13 en nitrure de gallium. La gravure des couches 17, 33 et 39 s'arrête ainsi lorsque la face supérieure de la couche 13 est dévoilée. L'étape de formation des ouvertures destinées à recevoir les métallisations de contact 29 et 31 est par exemple suivie d'une étape de nettoyage de la face supérieure de la structure, par exemple similairement à ce qui a été décrit ci-avant pour la métallisation de contact de grille 27 et la région 37. A titre d'exemple, une étape de préparation de la surface de la face supérieure de la couche 13 dans les ouvertures, en vue d'accueillir les métallisations de contacts 29 et 31, peut être prévue. Cette étape consiste par exemple en un nettoyage chimique à l'aide d'acide, par exemple de chlorure d'hydrogène (HCl).

Dans un second temps, les métallisations de contact de source 29 et de drain 31 sont, par exemple, formées dans les ouvertures précédemment réalisées. Les métallisations 29, 31 et une région 47 sont, par exemple, formées par dépôt d'une ou plusieurs couches en un matériau métallique sur l'ensemble de la face supérieure de la structure, ici la face supérieure des couches 13 et 39, suivie d'une étape de gravure.

La figure 4 est une vue en coupe, partielle et schématique, d'un transistor HEMT 43 selon un deuxième mode de réalisation.

Le transistor 43 illustré en figure 4 est similaire au transistor HEMT 41 illustré en figure 2 à la différence près que les parties périphériques de la grille 15 ne sont pas dopées du type N. Le procédé de fabrication du transistor 43 diffère du procédé de fabrication du transistor 41 en ce que, dans le procédé de fabrication du transistor 43, la deuxième étape de compensation est omise. En outre, le transistor 43 illustré en figure 4 est similaire au transistor HEMT 41 illustré en figure 2 à la différence près que l'étape de gravure décrite en relation avec la figure 3C est une gravure complète et que l'étape de poursuite de la gravure de la couche de grille 15 est omise.

Ainsi, dans le procédé de fabrication du transistor 43, la gravure de la couche de grille 15 est réalisée en une seule étape, c'est-à-dire que la couche de grille 15 est retirée hors du vis-à-vis de la couche de masquage 25 dans toute son épaisseur au cours d'une unique étape de gravure. Le procédé de fabrication du transistor 43 comprend, à la suite de l'étape de gravure de la couche de grille 15 de façon à former la grille 15, l'étape de formation des couches 17 et 33 similairement à ce qui a été décrit en relation avec la figure 3F.

Plus particulièrement, dans cet exemple, le transistor 43 est différent du transistor 41 en ce que la grille 15 ne comprend pas de parties périphériques 155 dopées du type N.

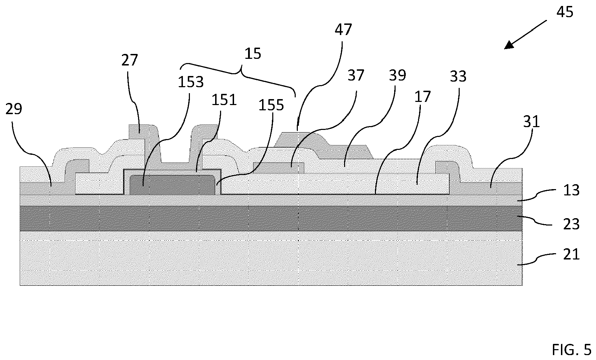

La figure 5 est une vue en coupe, partielle et schématique, d'un transistor HEMT 45 selon un troisième mode de réalisation.

Le transistor 45 illustré en figure 5 est similaire au transistor HEMT 41 illustré en figure 2 à la différence près que, dans le procédé de fabrication du transistor 45, les métallisations de contact de source 29 et de drain 31 ont été formées avant la formation de la métallisation de contact de grille 27 alors que dans le procédé de fabrication du transistor 41, les métallisations de contacts de source 29 et de drain 31 ont été formées après la formation de la métallisation de contact de grille 27.

Plus particulièrement, dans cet exemple, le transistor 45 est différent du transistor 41 en ce que la métallisation de contact de grille 27 traverse la couche 39 et en ce que la couche 39 recouvre les métallisations de contact 29 et 31.

Divers modes de réalisation et variantes ont été décrits. La personne du métier comprendra que certaines caractéristiques de ces divers modes de réalisation et variantes pourraient être combinées, et d'autres variantes apparaîtront à la personne du métier. En particulier, les deuxièmes et troisième modes de réalisation décrits respectivement aux figures 4 et 5 peuvent être combinés.

En outre, bien que l'on ait décrit ci-dessus un exemple de réalisation dans lequel la grille 15 du transistor est en contact avec la face supérieure de la couche semiconductrice supérieure 13, à titre de variante, la grille 15 peut être séparée de la couche semiconductrice 13 par une couche d'isolant de grille.

Par ailleurs, les modes de réalisation ne se limitent pas aux exemples de valeurs numériques ni aux exemples de matériaux mentionnés dans la présente description.

Enfin, la mise en oeuvre pratique des modes de réalisation et variantes décrits est à la portée de la personne du métier à partir des indications fonctionnelles données ci-dessus.

## Revendications

1. Procédé de formation d'un transistor HEMT (41) comportant les étapes successives suivantes :
a) prévoir un empilement comportant une couche semiconductrice de canal (23), une couche semiconductrice barrière (13) sur et en contact avec la couche semiconductrice de canal (23) et une couche semiconductrice de grille (15) disposée sur et en contact avec la couche semiconductrice barrière (13), la couche semiconductrice de grille (15) comportant des éléments dopants de type P ; et
b) compenser le dopage de type P par des atomes d'oxygène, dans une partie supérieure (151) de la couche semiconductrice de grille (15), par un recuit sous oxygène, de manière à définir une jonction PN à l'interface entre la partie supérieure (151) et une partie centrale (153) de la couche semiconductrice de grille (15).

2. Procédé selon la revendication 1, comportant une étape c) de gravure de la couche semiconductrice de grille (15).

3. Procédé selon la revendication 2, dans lequel la gravure de l'étape c) est réalisée après l'étape b).

4. Procédé selon la revendication 3, dans lequel :
- la gravure de l'étape c) est partielle, une partie de l'épaisseur de la couche semiconductrice de grille (15) subsistant à l'issue de l'étape de gravure ; et
- la gravure de l'étape c) est suivie d'une autre étape de compensation du dopage de type P par des atomes d'oxygène dans une partie périphérique de la couche semiconductrice (15) gravée et d'une autre étape de gravure permettant de retirer ce qui subsiste de la couche semiconductrice de grille (15) à l'issue de l'étape de gravure de l'étape c).

5. Transistor HEMT (11) comportant :
- une couche semiconductrice de canal (23) ;
- une couche semiconductrice barrière (13) sur et en contact avec la couche semiconductrice de canal (23) ; et
- une grille semiconductrice (15) disposée sur et en contact avec une première face de la couche semiconductrice barrière (13), opposée à la couche semiconductrice de canal (23),
dans lequel la grille (15) comprend une partie supérieure (151) et une partie centrale (153), la partie supérieure (151) et la partie centrale (153) comportant des éléments dopants de type P, et la partie supérieure (151) comportant des atomes d'oxygène compensant le dopage de type P de manière à définir une jonction PN à l'interface entre la partie centrale (153) et la partie supérieure (151).

6. Transistor selon la revendication 5, dans lequel la grille (15) comprend une partie périphérique (155) comportant des éléments dopants de type P et comportant des atomes d'oxygène compensant le dopage de type P.

7. Transistor selon la revendication 5 ou 6, comportant une couche de passivation (17) s'étendant sur la première face de la première couche semiconductrice (13) et les flancs de la grille (15) et une partie périphérique d'une face de la grille (15) opposée à la première couche semiconductrice (13) .

8. Transistor selon la revendication 7, dans lequel la première couche de passivation (17) est en alumine.

9. Transistor selon l'une quelconque des revendications 5 à 8, dans lequel la première couche semiconductrice (13) est à base de nitrure de gallium.

10. Transistor selon la revendication 9, dans lequel la première couche semiconductrice (13) est en nitrure d'aluminium-gallium.

11. Transistor selon la revendication 10, dans lequel la première couche semiconductrice comprend un pourcentage en aluminium décroissant à partir de sa première face.

12. Transistor selon l'une quelconque des revendications 5 à 11, comportant une deuxième couche semiconductrice (23) en contact avec une deuxième face de la première couche semiconductrice (13), opposée à la première face.

13. Transistor selon la revendication 12, dans lequel la deuxième couche semiconductrice (23) est en nitrure de gallium.

14. Transistor selon l'une quelconque des revendications 5 à 13, dans lequel la grille semiconductrice (15) est en nitrure de gallium.

15. Circuit de conversion ou d'adaptation de puissance comportant au moins un transistor selon l'une quelconque des revendications 5 à 14.
